(19)

Europäisches Patentamt
European Patent Office
Office européen des brevets

(11) **EP 3 813 091 A1**

(12) **EUROPEAN PATENT APPLICATION**

(43) Date of publication:
**28.04.2021 Bulletin 2021/17**

(21) Application number: **19204524.3**

(22) Date of filing: **22.10.2019**

(51) Int Cl.:
*H01J 37/153* (2006.01)          *H01J 37/22* (2006.01)
*H01J 37/28* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **SHAO, Yifeng**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING ABERRATIONS IN IMAGES OBTAINED BY A CHARGED PARTICLE BEAM TOOL, METHOD OF DETERMINING A SETTING OF A CHARGED PARTICLE BEAM TOOL, AND CHARGED PARTICLE BEAM TOOL**

(57)     A method of determining aberrations in images obtained by a charged particle beam tool, comprising the steps of: a) obtaining two or more images of a sample, wherein each image is obtained at a known relative difference in a measurement condition of the charged particle beam tool; b) selecting an estimated aberration parameter for the aberrations of a probe profile representing the charged particle beam used by the charged particle beam tool; c) evaluating an error function indicative of the difference between the two or more images and two or more estimated images that are a function of the estimated aberration parameter and the known relative difference in the measurement condition; d) updating the estimated aberration parameter; e) performing steps c) and d) iteratively; f) determining the final aberration parameter as the estimated aberration parameter that provides the smallest value of the error function.

Fig 3

**Description**

TECHNICAL FIELD

The present invention relates to a method of determining aberrations in images obtained by a charged particle beam tool. The present invention also relates to a method of determining a setting of a charged particle beam tool. The present invention also relates to a charged particle beam tool.

BACKGROUND

When manufacturing semiconductor integrated circuit (IC) chips, pattern defects and/or contaminant particles (residuals) inevitably appear on a wafer and/or a mask during fabrication processes, thereby reducing the yield to a great degree. For example, contaminant particles may be troublesome for patterns with smaller critical feature dimensions, which have been adopted to meet the more and more advanced performance requirements of IC chips.

Pattern inspection tools using a charged particle beam, such as an electron beam, have been used to detect the defects and/or contaminant particles. These tools typically employ a scanning electron microscope (SEM) or other charged particle beam tool. In the SEM, a beam of primary electrons having a relatively high energy is decelerated to land on a sample at a relatively low landing energy and is focused to form a probe spot thereon. Due to this focused probe spot of primary electrons, secondary electrons will be generated from the surface. By scanning the probe spot over the sample surface and collecting the secondary electrons, pattern inspection tools may obtain an image of the sample surface. Aberrations in the profile of the probe spot may reduce the spatial resolution of the image.

SUMMARY

It is thus desirable, for example, to provide a method of determining aberrations in images obtained from a charged particle beam tool.

According to an aspect of the invention, there is provided a method of determining aberrations in images obtained by a charged particle beam tool, the method comprising the steps of: a) obtaining two or more images of a sample using the charged particle beam tool, wherein each image is obtained at a known relative difference in a measurement condition of the charged particle beam tool; b) selecting an estimated aberration parameter for the aberrations of a probe profile representing the charged particle beam used by the charged particle beam tool; c) evaluating an error function indicative of the difference between the two or more images and two or more estimated images that are a function of the estimated aberration parameter and the known relative difference in the measurement condition; d) updating the estimated aberration parameter; e) performing steps c) and d) iteratively; and f) determining the final aberration parameter as the estimated aberration parameter that provides the smallest value of the error function.

According to an aspect of the invention, there is provided a method of determining a setting of the charged particle beam tool, the method comprising: performing the method of determining aberrations in images obtained by a charged particle beam tool two or more times, each time based on a different estimate for the setting of the charged particle beam tool, determining a residual error for each estimate of the setting by evaluating the error function based on the final aberration parameter determined for the respective estimate of the setting, and determining as the setting of the charged particle beam tool the estimate of the setting resulting in the smallest residual error

According to another aspect of the invention, there is provided a charged particle beam tool comprising an illumination system configured to generate a charged particle beam and scan the charged particle beam across a sample, a detection system configured to capture charged particles interacting with the sample, thereby creating an image of the sample, and a controller configured to perform the method.

According to another aspect of the invention, there is provided a computer program product comprising instructions which, when the program is executed by a computer, cause the computer to carry out the method.

According to another aspect of the invention, there is provided a computer-readable storage medium comprising instructions which, when executed by a computer, cause the computer to carry out the method.

BRIEF DESCRIPTION OF DRAWINGS

Embodiments of the invention will now be described, by way of example only, with reference to the accompanying schematic drawings in which corresponding reference symbols indicate corresponding parts, and in which:

Figure 1 schematically depicts a charged particle beam system;
Figure 2 schematically depicts a charged particle beam tool;
Figure 3 schematically depicts a method of determining aberrations in images obtained by a charged particle beam tool;
Figure 4 schematically depicts a method of determining a setting of a charged particle beam tool; and
Figures 5 and 6 shows experimental results.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, while reducing the physical size of the devices, can be accomplished by significantly increasing the packing density of circuit components such as transistors, capacitors, diodes, etc. on an IC chip. For example, an IC chip of a smart phone, which is the size of a thumbnail, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Even one "killer defect" can cause device failure. The goal of the manufacturing process is to improve the overall yield of the process. For example, for a 50-step process to get to a 75% yield, each individual step must have a yield greater than 99.4%, and if the individual step yield is 95%, the overall process yield drops to 7%.

While high process yield is desirable in an IC chip manufacturing facility, maintaining a high substrate (i.e. wafer) throughput, defined as the number of substrates processed per hour, is also important. High process yield and high substrate throughput can be impacted by the presence of defects, especially if operator intervention is required for reviewing the defects. Thus, high throughput detection and identification of micro and nano-sized defects by a charged particle beam tool (such as an electron beam tool, in particular an SEM) is essential for maintaining high yield and low cost.

An electron beam tool, such as an electron beam inspection tool, comprises an illumination system that generates and scans a sample, such as a substrate, with one or more focused beams of primary electrons. The primary electrons interact with the sample and generate secondary electrons. The electron beam tool also comprises a detection system. By capturing the secondary electrons from the sample as the sample is scanned, the electron beam tool creates an image of the scanned area of the sample.

A known charged particle beam tool, for example a charged particle beam inspection tool, is described below.

Relative dimensions of components in drawings may be exaggerated for clarity. Within the following description of drawings the same or like reference numbers refer to the same or like components or entities, and only the differences with respect to the individual embodiments are described. As used herein, unless specifically stated otherwise, the term "or" encompasses all possible combinations, except where infeasible. For example, if it is stated that an apparatus can include A or B, then, unless specifically stated otherwise or infeasible, the apparatus can include A, or B, or A and B. As a second example, if it is stated that the apparatus can include A, B, or C, then, unless specifically stated otherwise or infeasible, the apparatus can include A, or B, or C, or A and B, or A and C, or B and C, or A and B and C.

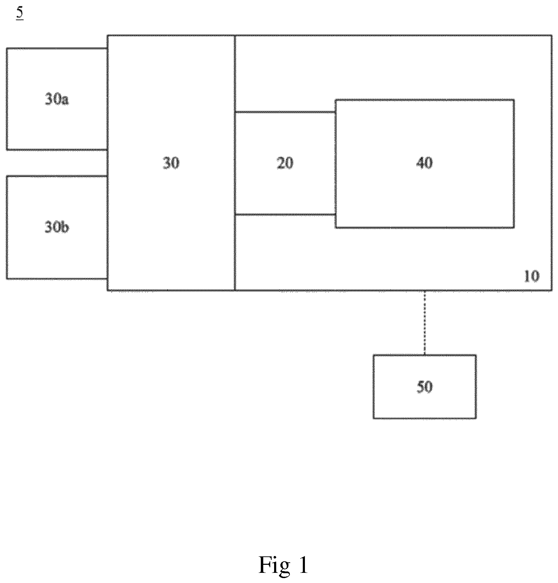

Reference is now made to **FIG. 1,** which is a schematic diagram illustrating an exemplary charged particle beam system 5. The charged particle beam system 5 may be a charged particle beam inspection system. The charged particle beam system 5 may be an electron beam system 5, such as an electron beam inspection system 5. As shown in **FIG. 1,** charged particle beam system 5 includes a main chamber 10, a load lock chamber 20, a charged particle beam tool 40 (such as a charged particle beam inspection tool 40), and an equipment front end module (EFEM) 30. Charged particle beam tool 40 is located within main chamber 10. While the description and drawings are directed to an electron beam, it is appreciated that the embodiments are not used to limit the present disclosure to specific charged particles. Charged participles other than electrons could be used in the present invention.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 may be connected to a load lock vacuum pump system (not shown), which removes gas molecules in load lock chamber 20 to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown), which removes gas molecules in main chamber 10 to reach a second pressure below the first pressure. After reaching the second pressure, the sample is subject to inspection by charged particle beam tool 40.

A controller 50 is electronically connected to charged particle beam tool 40. Controller 50 may be a computer configured to execute various controls of charged particle beam system 5. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure.

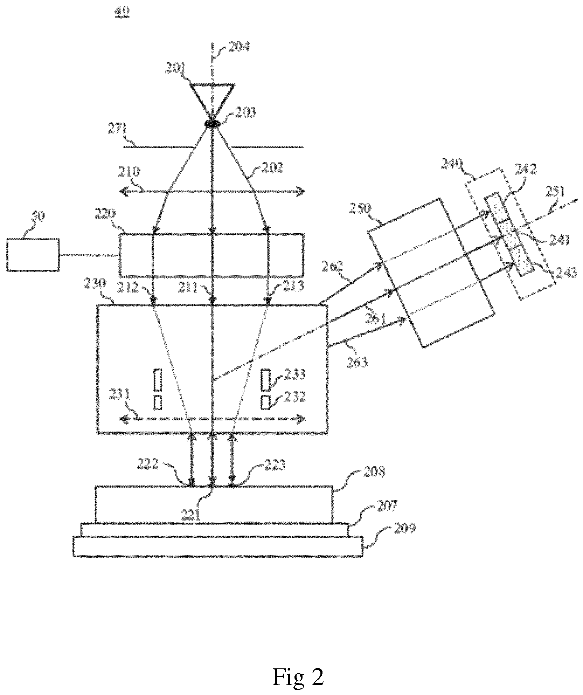

The charged particle beam tool 40 may be a charged particle beam inspection tool. The charged particle beam tool 40 may be an electron beam tool 40, such as an electron beam inspection tool 40. The charged particle beam tool 40 may comprise a single-beam tool. Alternatively, the charged particle beam tool 40 may comprise a multi-beam tool. A multi-beam tool will be described with reference to **FIG. 2** in the following, but it will be appreciated that the present invention is not limited to such a multi-beam tool, but may also be performed with a single-beam tool.

Reference is now made to **FIG. 2,** which is a schematic diagram illustrating an exemplary charged particle beam tool 40, in particular an electron beam tool, including a multi-beam tool that is part of the exemplary charged particle beam system 5 of **FIG. 1.** The charged particle beam tool 40 may comprise a charged particle source 201 (e.g. an electron source 201), a gun aperture plate 271, a condenser lens 210, a source conversion unit 220, a primary projection system 230, a motorized stage 209, and a sample holder 207 supported by the motorized stage 209 to hold a sample 208 (e.g., a sample or a photomask) to be inspected. The charged particle beam tool 40 may further comprise a secondary projection system 250 and a detection device 240 (e.g. an electron detection device). The primary projection system 230 may comprise an objective lens 231. The detection device 240 may comprise a plurality of detection elements 241, 242, and 243. A beam separator 233 and a deflection scanning unit 232 may be positioned inside primary projection system 230.

The charged particle source 201, the gun aperture plate 271, the condenser lens 210, the source conversion unit 220, the beam separator 233, the deflection scanning unit 232, and the primary projection system 230 may be aligned with a primary optical axis 204 of the charged particle beam tool 40. The secondary projection system 250 and the detection device 240 may be aligned with a secondary optical axis 251 of the charged particle beam tool 40.

The primary optical axis 204 is the optical axis of the part of the charged particle beam tool 40 that is the illumination system. The secondary optical axis 251 is the optical axis of the part of the charged particle beam tool 40 that is the detection system. The primary optical axis 204 may also be referred to herein as the primary electro-optical axis or charged particle optical axis. The secondary optical axis 251 may also be referred to herein as the secondary electro-optical axis or the secondary charged particle optical axis.

Charged particle source 201 may be an electron source, and may comprise a cathode (not shown) and an extractor or anode (not shown), in which, during operation, charged particle source 201 is configured to emit primary electrons or other charged particles from the cathode and the primary electrons or other charged particles are extracted or accelerated by the extractor and/or the anode to form a primary charged particle beam 202, such as a primary electron beam 202, that forms a primary beam crossover (virtual or real) 203. Primary charged particle beam 202 may be visualized as being emitted from primary beam crossover 203.

Source conversion unit 220 may comprise an image-forming element array, an aberration compensator array, a beam-limit aperture array, and a pre-bending micro-deflector array. The pre-bending micro-deflector array may deflect a plurality of primary beamlets 211, 212, 213 of primary charged particle beam 202 to normally enter the beam-limit aperture array, the image-forming element array, and an aberration compensator array. Beamlets 211, 212, 213 are also referred to herein as sub-beams. The primary charged particle beam 202 may comprise the plurality of primary beamlets 211, 212, 213. Condenser lens 210 may be designed to focus primary charged particle beam 202 to become a parallel beam and be normally incident onto source conversion unit 220. The image-forming element array may comprise a plurality of micro-deflectors or micro-lenses to influence the plurality of primary beamlets 211, 212, 213 of primary electron beam 202 and to form a plurality of parallel images (virtual or real) of primary beam crossover 203, one for each of the primary beamlets 211, 212, 213. The aberration compensator array may comprise a field curvature compensator array (not shown) and an astigmatism compensator array (not shown). The field curvature compensator array may comprise a plurality of micro-lenses to compensate field curvature aberrations of the primary beamlets 211, 212, 213. The astigmatism compensator array may comprise a plurality of micro-stigmators to compensate astigmatism aberrations of the primary beamlets 211, 212, 213. The beam-limit aperture array may be configured to limit diameters of individual primary beamlets 211, 212, 213. **FIG. 2** shows three primary beamlets 211, 212, 213 as an example, and it is appreciated that source conversion unit 220 may be configured to form any number of primary beamlets. Alternatively, a single charged particle beam 202 may be provided, and the source conversion unit 220 may comprise a single image-forming element, a single aberration compensator (comprising a single field curvature compensator and a single astigmatism compensator), a single beam-limit aperture, and a single pre-bending micro-deflector. The controller 50 may be connected to various parts of charged particle beam system 5 of **FIG. 1,** such as source conversion unit 220, electron detection device 240, primary projection system 230, or motorized stage 209. As explained in further details below, the controller 50 may perform various image and signal processing functions. The controller 50 may also generate various control signals to govern operations of the charged particle beam system 5.

Condenser lens 210 is configured to focus primary charged particle beam 202. Condenser lens 210 may further be configured to adjust electric currents of primary beamlets 211, 212, 213 downstream of source conversion unit 220 by varying the focusing power of the condenser lens 210. Alternatively, the electric currents may be changed by altering the radial sizes of beam-limit apertures within the beam-limit aperture array corresponding to the individual primary beamlets. The electric currents may be changed by both altering the radial sizes of beam-limit apertures and the focusing power of condenser lens 210. Condenser lens 210 may be a movable condenser lens that may be configured so that the position of its first principle plane is movable. The movable condenser lens may be configured to be magnetic, which may result in off-axis beamlets 212 and 213 illuminating source conversion unit 220 with rotation angles. The rotation angles change with the focusing power or the position of the first principal plane of the movable condenser lens. Condenser lens 210 may be an anti-rotation condenser lens that may be configured to keep the rotation angles unchanged while the focusing power of condenser lens 210 is changed. Condenser lens 210 may be a movable anti-rotation condenser lens, in which the rotation angles do not change when its focusing power and the position of its first principal plane are varied.

The objective lens 231 may be configured to focus beamlets 211, 212, 213 onto a sample 208 for inspection and may form three probe spots 221, 222, 223 on the surface of sample 208. Alternatively, in a single-beam tool, the objective lens 231 may be configured to focus the primary charged particle beam 202 onto the sample 208 and may form a single probe spot 221 on the surface of the sample 208. Gun aperture plate 271, in operation, is configured to block off peripheral electrons of primary electron beam 202 to reduce the Coulomb effect. The Coulomb effect may enlarge the size of each of probe spots 221, 222, 223 of primary beamlets 211, 212, 213, and therefore deteriorate inspection resolution. A gun aperture plate 271 may also be referred to as a coulomb aperture array.

Beam separator 233 may, for example, be a Wien filter comprising an electrostatic deflector generating an electrostatic dipole field and a magnetic dipole field (not shown **in FIG. 2**). In operation, beam separator 233 may be configured to exert an electrostatic force by electrostatic dipole field on individual charged particles of primary beamlets 211, 212, 213 or primary charged particle beam 202. The electrostatic force is equal in magnitude but opposite in direction to the magnetic force exerted by magnetic dipole field of beam separator 233 on the individual electrons. Primary beamlets 211, 212, 213 or primary charged particle beam 202 may therefore pass at least substantially straight through beam separator 233 with at least substantially zero deflection angles.

Deflection scanning unit 232, in operation, is configured to deflect primary beamlets 211, 212, 213 to scan probe spots 221, 222, 223 across individual scanning areas in a section of the surface of the sample 208. In response to incidence of primary beamlets 211, 212, 213 or probe spots 221, 222, 223 on the sample 208, electrons emerge from the sample 208 and generate three secondary electron beams 261, 262, 263. Each of the secondary electron beams 261, 262, 263 typically comprises secondary electrons (having electron energy $\leq$ 50eV) and backscattered electrons (having electron energy between 50eV and the landing energy of primary beamlets 211, 212, 213). Beam separator 233 is configured to deflect secondary electron beams 261, 262, 263 towards secondary projection system 250. Secondary projection system 250 subsequently focuses secondary electron beams 261, 262, 263 onto detection elements 241, 242, 243 of electron detection device 240. Detection elements 241, 242, 243 are arranged to detect corresponding secondary electron beams 261, 262, and 263 and generate corresponding signals which are sent to controller 50 or a signal processing system (not shown), e.g. to construct images of the corresponding scanned areas of sample 208.

Detection elements 241, 242, 243 may detect corresponding secondary electron beams 261, 262, 263, respectively, and generate corresponding intensity signal outputs (not shown) to an image processing system (e.g., controller 50). Each detection element 241, 242, and 243 may comprise one or more pixels. The intensity signal output of a detection element may be a sum of signals generated by all the pixels within the detection element. In a single-beam tool, a single detection element 241 may be provided.

The controller 50 may comprise an image processing system that includes an image acquirer (not shown) and a storage device (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to detection device 240 of charged particle beam tool 40 through a medium such as an electrical conductor, optical fiber cable, portable storage media, IR, Bluetooth, internet, wireless network, wireless radio, among others, or a combination thereof. The image acquirer may receive a signal from detection device 240 and may construct an image. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from detection device 240. An imaging signal may correspond to a scanning operation for conducting charged particle imaging.

An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of the sample 208 sampled multiple times over a time sequence. The multiple images may be stored in the storage. The controller 50 may be configured to perform image processing steps with the multiple images of the same location of the sample 208.

The controller 50 may control motorized stage 209 to move sample 208 during inspection of sample 208. The controller 50 may enable motorized stage 209 to move sample 208 in a direction continuously at a constant speed. The controller 50 may enable motorized stage 209 to change the speed of the movement of sample 208 overtime depending on the steps of scanning process.

Although **FIG. 2** shows that the charged particle beam tool 40 uses three primary electron beams, the charged particle beam tool 40 may use two or more primary electron beams. The charged particle beam tool 40 may also use a single primary charged particle beam 202 instead of beamlets 211, 212, 213. The present disclosure does not limit the number of primary electron beams used in charged particle beam tool 40.

The charged particle beam tool 40, in particular the electron beam tool 40, may create an image of the sample 208. The image may be an image created by the primary charged particle beam 202 of a single-beam tool or an image created by one of the beamlets 211, 212, 213 of a multi-beam tool. The created image comprises a contribution that is due to the secondary electrons emitted by the sample 208 (herein referred to as the object) and a contribution due to the shape or profile of the primary charged particle beam 202 or of one of the beamlets 211, 212, 213 that is incident on the sample (herein referred to as the probe profile).

The image $I_z(r)$ in the z plane (i.e. the plane at distance z with respect to the plane of focus) may be expressed as the convolution of the object $O(r)$ and the probe profile $H_z(r; \zeta)$ in the z plane, i.e. as

$$I_z(\boldsymbol{r}) = O(\boldsymbol{r}) * H_z(\boldsymbol{r}; \boldsymbol{\zeta}).$$

The probe profile $H_z(r; \zeta)$ is the shape or profile of the primary charged particle beam 202 in the z plane in which the sample 208, or specifically the surface of the sample 208, is located, i.e. a plane orthogonal to the primary optical axis 204 and at a position z relative to the plane of focus of the objective lens 231 along the primary optical axis 204. In the plane of focus of the objective lens 231, z=0. The probe profile $H_z(r; \zeta)$ is dependent on the aberration $\zeta$ for a specific charged particle wavelength $\lambda$ (which depends on the kinetic energy or landing energy of the charged particle) and the numerical aperture NA of the objective lens 231. In analogy to optics, the probe profile $H_z(r; \zeta)$ corresponds to the intensity of the point-spread function (PSF).

In the spatial frequency domain,

$$\hat{I}_z(\boldsymbol{k}) = \hat{O}(\boldsymbol{k}) \times \hat{H}_z(\boldsymbol{k}; \boldsymbol{\zeta}),$$

where $\hat{I}_z(\boldsymbol{k})$ is the Fourier transform of the image $I_z(\boldsymbol{r})$, $\hat{O}(\boldsymbol{k})$ is the Fourier transform of the object $O(\boldsymbol{r})$, and $\hat{H}_z(\boldsymbol{k}; \zeta)$ is the Fourier transform of the probe profile $H_z(\boldsymbol{r}; \zeta)$, and k is the spatial frequency component. As such, the Fourier transform of the image is the product of the Fourier transform of the object and the Fourier transform of the probe profile. In analogy to optics, the Fourier transform of the probe profile may also be referred to as the optical transfer function. In the following, the terms "Fourier transform of the object" and "object", "Fourier transform of the image" and "image" and "Fourier transform of the probe profile" and "probe profile" will be used interchangeably.

The wavefront of an ideal focused charged particle beam is a perfect sphere that is centered at the point of focus in the plane of focus. In reality, the aberrations deform the probe profile so as to deviate from the ideal wavefront. As a result, the spatial resolution of the image $I_z(r)$ may be negatively affected, even when the sample 208 is in the plane of focus of the charged particle beam tool 40. It is thus desirable to determine and remove or reduce the aberrations in the image $I_z(r)$, i.e. to determine and remove or reduce from the image $I_z(r)$ the contributions of the probe profile to the image $I_z(r)$ that are due to the aberrations.

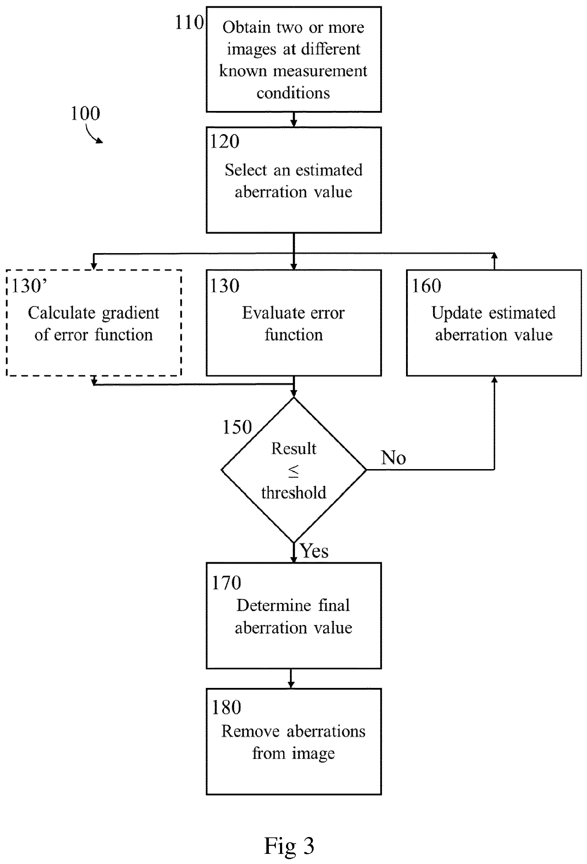

**FIG. 3** shows a method 100 of determining aberrations in images obtained by the charged particle beam tool 40, in accordance with an embodiment of the present invention. The image may be an image created by the primary charged particle beam 202 of a single-beam tool or an image created by one of the beamlets 211, 212, 213 of a multi-beam tool. The aberrations in each beamlet 211, 212, 213 of a multi-beam tool may be different. If the aberrations for each beamlet 211, 212, 213 are relatively similar, then the aberrations determined for one of the beamlets 211, 212, 213 may be considered to correspond to the aberrations of the other beamlets 211, 212, 213. Alternatively, if the aberrations for each beamlet 211, 212, 213 are relatively different, then the method 100 may be performed for each of the beamlets 211, 212, 213 separately, so as to determine the respective aberrations for each of the beamlets 211, 212, 213.

The method 100 comprises a step 110 of obtaining two or more images of the sample 208 using the charged particle beam tool 40. The two or more images are of the same sample 208. Each image is obtained at a known relative difference in a measurement condition of the charged particle beam tool 40. The method 100 may comprise obtaining an image of the sample 208 at a first value of the measurement condition, adjusting the first value by a known difference in value of the measurement condition (i.e. in a known fashion) to a second value of the measurement condition, and obtaining an image of the sample 208 at the second value of the measurement condition. Optionally, the first and second values of the measurement condition may also be known. The method 100 may further comprise adjusting the value of the second measurement condition by one or more known relative differences to further values of the measurement condition, and obtaining an image of the sample 208 at each further value of the measurement condition. Optionally, the further values of the measurement conditions may also be known.

The measurement condition of the charged particle beam tool 40 may comprise a position of the sample 208, in particular of the surface of the sample 208, along the primary optical axis 204 relative to the plane of focus of the objective lens 231. The position of the sample 208 along the primary optical axis 204 relative to the plane of focus of the objective lens 231 may be adjusted by adjusting the amount of focusing of the objective lens 231, so as to move the plane of focus of the objective lens 231. For this purpose, the charged particle beam tool 40 may comprise the objective lens 231. Adjusting the amount of focusing of the objective lens 231 may affect the numerical aperture NA of the charged particle tool 40. The effect of the varying numerical aperture on the images may, however, be negligible compared to the effect of the varying position of the plane of focus on the images.

Alternatively or additionally, the position of the sample 208 along the primary optical axis 204 relative to the plane of focus of the objective lens 231 may be adjusted by moving the sample 208 in the direction along the primary optical axis 204. For this purpose, the charged particle beam tool 40 may comprise the motorized stage 209 for adjusting the position of the sample 208 in the direction along the primary optical axis 204. Moving the sample 208 may not affect the numerical aperture NA of the charged particle tool 40.

Alternatively or additionally, the measurement condition of the charged particle beam tool 40 may comprise an amount of beam shaping applied to the primary charged particle beam 202 by the charged particle beam tool 40. The amount of beam shaping may, for example, comprise an amount of aberration correction, such as an amount of field curvature compensation applied to the charged particle beam 202 and/or an amount of astigmatism compensation applied to the charged particle beam 202. For this purpose, the charged particle beam tool 40 may comprise the aberration compensator or any other beam shaping element. The aberration compensator may comprise the field curvature compensator and/or the astigmatism compensator.

Alternatively or additionally, the measurement condition of the charged particle beam tool 40 may comprise an average landing energy of the charged particles used in the charged particle beam tool 40. The average landing energy of the charged particles may be adjusted, for example, by adjusting the operating conditions of the charged particle source 201, such as the voltage applied to the extractor and/or the anode of the charged particle source 201. For this purpose, the charged particle beam tool 40 may comprise the charged particle source 201. Additionally or alternatively, the average landing energy of the charged particles may be adjusted by decelerating the charged particles between the objective lens 231 and the sample 208, for example by creating a suitable electric field between the objective lens 231 and the sample 208. For this purpose, the charged particle beam tool 40 may comprise the objective lens 231.

The measurement condition may also comprise any combination of the measurement conditions provided above.

The method 100 further comprises a step 120 of selecting an estimated aberration parameter $\zeta$ for the aberrations of the probe profile representing the primary charged particle beam 202. The estimated aberration parameter $\zeta$ may comprise one or more estimated aberration values (i.e. $\zeta = [\zeta_1, \zeta_2, ...]$), for example one estimated aberration value per Zernike polynomial that is used to account for the aberrations in the image. The estimated aberration parameter $\zeta$ may be a vector comprising or consisting of one or more estimated aberration values ($\zeta = [\zeta_1, \zeta_2,...]$), preferably 15 or more estimated aberration values, further preferably 37 or more estimated aberration values. Selecting the estimated aberration parameter $\zeta$ may comprise selecting each of the estimated aberration values comprised by the estimated aberration parameter $\zeta$. Selecting the estimated aberration parameter $\zeta$ may comprise choosing or setting the estimated aberration parameter $\zeta$ to an initial guess or estimate for the actual aberration parameter. The initial guess or estimate may be predetermined. For example, the initial estimated aberration values may all be 0. Alternatively, the initial guess or estimate may be based on an estimated aberration parameter $\zeta$ that was determined earlier for the charged particle beam tool 40, e.g. when the method 100 was last performed. Further alternatively, an operator of the charged particle beam tool 40 may freely choose the initial guess or estimate.

The method 100 further comprises a step 130 of evaluating an error function. The error function is indicative of the difference between the two or more images and two or more estimated images. The two or more estimated images are a function of the estimated aberration parameter $\zeta$ and the known relative difference in the measurement condition. The two or more estimated images may be a function of the estimated aberration parameter $\zeta$ and the known value of the measurement condition. The two or more estimated images may further be based on settings of the charged particle beam tool 40, such as the numerical aperture NA of the objective lens 231 and the wavelength λ of the charged particles. The settings of the charged particle beam tool 40 may be at least approximately known.

The step 130 of evaluating the error function may comprise calculating an estimated probe profile for each image based on the estimated aberration parameter $\zeta$ and the known relative difference in the measurement condition. The estimated probe profile may be based on the estimated aberration parameter $\zeta$ and the known value of the measurement condition. The estimated probe profile may further be based on the settings of the charged particle beam tool 40. The step S130 may further comprise calculating, for each image of the two or more images, the difference between the image and an estimated image that is based on the respective estimated probe profile, and summing the calculated differences.

For example, the two or more images may be represented in the spatial frequency domain as a set of linear equations:

$$\hat{I}_{z1}(\boldsymbol{k}) = \hat{O}(\boldsymbol{k})\hat{H}_{z1}(\boldsymbol{k}; \boldsymbol{\zeta})$$

$$\hat{I}_{z2}(\boldsymbol{k}) = \hat{O}(\boldsymbol{k})\hat{H}_{z1}(\boldsymbol{k}; \boldsymbol{\zeta})$$

$$\ldots \qquad \ldots \qquad \ldots$$

$$\hat{I}_{zn}(\boldsymbol{k}) = \hat{O}(\boldsymbol{k})\hat{H}_{zn}(\boldsymbol{k}; \boldsymbol{\zeta})$$

where $\hat{I}_{zn}(\boldsymbol{k})$ is a respective image, $\hat{O}(\boldsymbol{k})$ is the object and $\hat{H}_{zn}(\boldsymbol{k}; \zeta)$ is a respective probe profile. The measurement condition differs by a known relative difference for each image. The object $\hat{O}(\boldsymbol{k})$ represents the contribution of the sample 208 to the image $\hat{I}_{zn}(\boldsymbol{k})$, and so is identical in each of the linear equations.

The set of linear equations can be solved for the object $\hat{O}(\boldsymbol{k})$ to provide a solution for $\hat{O}(\boldsymbol{k})$:

$$\hat{O}(\boldsymbol{k}) = \frac{\sum_{z1}^{zn} \hat{I}_z(\boldsymbol{k})\hat{H}_z(\boldsymbol{k}; \boldsymbol{\zeta})^*}{\sum_{z1}^{zn} \left|\hat{H}_z(\boldsymbol{k}; \boldsymbol{\zeta})\right|^2}$$

where $\hat{H}_z(\boldsymbol{k}; \zeta)^*$ represents the complex conjugate of $\hat{H}_z(\boldsymbol{k}; \zeta)$.

The error function $L(\zeta)$, which is indicative of the difference between the two or more images $\hat{I}_z(\boldsymbol{k})$ and two or more estimated images that are a function of the estimated aberration parameter and the known relative difference in the measurement condition (and optionally the known value of the measurement condition), may be expressed as:

$$L(\boldsymbol{\zeta}) = \sum_z \int \left|\hat{I}_z(\boldsymbol{k}) - \hat{O}(\boldsymbol{k})\hat{H}_z(\boldsymbol{k}; \boldsymbol{\zeta})\right|^2 \mathrm{d}\boldsymbol{k}$$

where $\hat{I}_z(\boldsymbol{k})$ is a respective one of the two or more images in the plane at distance z with respect to the plane of focus, and the respective estimated image is calculated as $\hat{O}(\boldsymbol{k})\hat{H}_z(\boldsymbol{k}; \zeta)$, where $\hat{H}_z(\boldsymbol{k}; \zeta)$ is the respective estimated probe profile. Inserting the solution for $\hat{O}(\boldsymbol{k})$ and reordering the terms leads to the error function $L(\zeta)$:

$$L(\boldsymbol{\zeta}) = \sum_z \int \left[ \frac{\left|\sum_z \hat{I}_z(\boldsymbol{k})\hat{H}_z(\boldsymbol{k}; \boldsymbol{\zeta})^*\right|^2}{\sum_z \left|\hat{H}_z(\boldsymbol{k}; \boldsymbol{\zeta})\right|^2} - \sum_z \left|\hat{I}_z(\boldsymbol{k})\right|^2 \right] \mathrm{d}\boldsymbol{k}$$

The method 100 may also comprise a step 130' of calculating a gradient $L'(\zeta)$ of the error function with respect to the aberration parameter $\zeta$ (where the aberration parameter $\zeta$ may be a vector $\zeta = [\zeta_1, \zeta_2, \ldots]$) based on the estimated aberration parameter $\zeta$. The step S130' may be performed after step S130 of evaluating the error function $L(\zeta)$, before step S130 of evaluating the error function $L(\zeta)$, or in parallel with step S130 of evaluating the error function $L(\zeta)$. The gradient $L'(\zeta)$ of the error function with respect to the aberration parameter $\zeta$ may be calculated as:

$$L'(\zeta) = \sum_z \int 2\Re \left\{ \frac{\left[ \sum_z \hat{I}_z(\boldsymbol{k}) \hat{H}_z(\boldsymbol{k}; \zeta)^* \right] \left[ \sum_z \hat{I}_z(\boldsymbol{k})^* \hat{H}_z{}'(\boldsymbol{k}; \zeta) \right]}{\sum_z |\hat{H}_z(\boldsymbol{k}; \zeta)|^2} \right.$$

$$\left. - \frac{\left| \sum_z \hat{I}_z(\boldsymbol{k}) \hat{H}_z(\boldsymbol{k}; \zeta)^* \right|^2 \left[ \sum_z \hat{H}_z(\boldsymbol{k}; \zeta)^* \hat{H}_z{}'(\boldsymbol{k}; \zeta) \right]}{\left( \sum_z |\hat{H}_z(\boldsymbol{k}; \zeta)|^2 \right)^2} \right\} d\boldsymbol{k}$$

where $\Re$ represents the real part of the term in brackets, and $\hat{H}_z{}'(\boldsymbol{k}; \zeta)$ represents the gradient of $\hat{H}_z(\boldsymbol{k}; \zeta)$ with respect to the aberration parameter $\zeta$.

The gradient $L'(\zeta)$ of the error function may be indicative of the difference between the two or more images and two or more estimated images that are a function of the estimated aberration parameter and the known relative difference in the measurement condition (optionally the known value of the measurement condition). The gradient $L'(\zeta)$ may also provide information for updating the estimated aberration parameter. The estimated aberration parameter may be updated until the value of the error function is sufficiently small and/or the gradient $L'(\zeta)$ is so small that the value of the error function cannot be further decreased. As such, step 130 of evaluating the error function may comprise evaluating the gradient $L'(\zeta)$ of the error function.

The probe profile $\hat{H}_z(\boldsymbol{k}; \zeta)$ may be calculated based on the estimated aberration parameter $\zeta$ and the known relative difference in the measurement condition (or based on the known value of the measurement condition). The settings of the charged particle tool 40, such as the numerical aperture NA of the charged particle tool 40 and the average wavelength of the charged particle tool 40, may also be taken into account in the calculation of the probe profile $\hat{H}_z(\boldsymbol{k}; \zeta)$. For example, the probe profile $\hat{H}_z(\boldsymbol{r}; \zeta)$ may comprise a contribution due to aberrations (as represented by the aberration parameter $\zeta$) and a contribution due to the position z of the sample 208 relative to the plane of focus (z = 0) of the objective lens 231.

The contribution due to the aberrations may be expressed in terms of the pupil function P(k). The pupil function P(k) is indicative of the amplitude and the phase of the charged particle beam in the plane of the objective lens 231, i.e. in the pupil plane. In the ideal case (i.e. if no aberrations are present), the pupil function $P(k)$ has both uniform amplitude and phase. In practice, aberrations are expressed as deviations from the uniform amplitude and phase.

Aberrations may cause deviation from both the uniform amplitude and the uniform phase. Aberrations may be represented using the Zernike polynomials. Each Zernike polynomial corresponds to a particular type of aberration. The pupil function $P(k)$ may thus be expressed as:

$$P(\boldsymbol{k}) = \left[ \sum_i \zeta_i Z_i(\boldsymbol{k}) \right] \exp \left\{ i2\pi \left[ \sum_j \zeta_j Z_j(\boldsymbol{k}) \right] \right\}$$

where $Z_{i,j}(\boldsymbol{k})$ is the Zernike polynomial, $\zeta_{i,j}$ is the corresponding weight (i.e. the respective aberration value of the aberration parameter $\zeta$), and i and j represent the indices of the amplitude and the phase respectively. In an embodiment, only the set of $\zeta_j$ is considered to represent the aberrations of the charged particle beam tool 40. Optionally, the set of $\zeta_i$ may also be considered. In an embodiment, at least the first 15 Zernike polynomials are taken into account, and the aberration parameter is a vector comprising at least 15 aberration values $\zeta = \zeta_1, \zeta_2, ..., \zeta_{15}$. In another embodiment, at least the first 37 Zernike polynomials are taken into account, and the aberration parameter is a vector comprising at least 37 aberration values $\zeta = \zeta_1, \zeta_2, ..., \zeta_{37}$.

The contribution due to the position z of the sample 208 relative to the plane of focus (z=0) of the objective lens 231 may be expressed by a defocus term, in particular by the defocus term $\exp(i\pi z|\boldsymbol{k}|^2)$. For example, the probe profile in the image plane at position z may be calculated as:

$$H_z(\boldsymbol{r}) = |FT\{P(\boldsymbol{k}) \exp(i\pi z|\boldsymbol{k}|^2)\}(\boldsymbol{r})|^2$$

where FT represents the Fourier transform and $\hat{H}_z(\boldsymbol{k}; \zeta) = FT\{H_z(\boldsymbol{r})\}(\boldsymbol{k})$.

In analogy to optics, the propagation of charged particles (e.g. electrons) from the pupil (i.e. the plane of the objective lens 231) to the image plane is described using the Fourier transform FT, r and k are coordinates of the pupil and the image plane respectively, P(k) is the pupil function of the charged particle beam, and $\exp(i\pi z|\boldsymbol{k}|^2)$ represents the defocus term (which will be equal to 1 in the plane of focus z=0). Here, r is normalized by a factor of $\lambda$/NA, where A is the wavelength of the charged particles and NA is the numerical aperture (half focusing angle) of the objective lens 231. The factor $\lambda$/NA determines the scaling of the size of the probe profile. The wavelength A of the charged particles is related to the kinetic energy (or landing energy) of the charged particles. For example, for electrons the wavelength can be calculated as

$$\lambda = 6.62 \times 10^{-34} / \sqrt{2 \times 9.1 \times 10^{-31} \times 1.6 \times 10^{-19} E},$$

where $6.62 \times 10^{-34} \frac{m^2 kg}{s}$ is the Planck constant, $9.1 \times 10^{-31}$ $kg$ is the electron rest mass, $1.6 \times 10^{-19}$ C is the electron elementary charge and E is the kinetic energy. The numerical aperture NA and the wavelength $\lambda$ may be settings of the charged particle beam tool 40, and may be at least approximately known to an operator of the charged particle beam tool 40.

Optionally, additional contributions to the probe profile $H_z(r)$ may be taken into account.

For example, in the charged particle beam tool 40, the charged particles emitted by the charged particle source 201 may have a distribution of kinetic energy. This distribution of kinetic energy induces a defocusing effect, because charged particles at different speeds will be focused at different locations along the primary optical axis 204. As a result, the overall probe profile will be a weighted sum of the probe profile for charged particles of each kinetic energy. The term of the induced defocus may be expressed as, for example:

$$\Phi(\mathbf{k}; \Delta E) = \frac{1}{2} \frac{\Delta E}{E} \frac{C_c}{\lambda} \mathrm{NA}^2 |\mathbf{k}|^2,$$

where E is the nominal or average kinetic energy, $\Delta E$ is the deviation from $E$, and $C_c$ is a coefficient of chromatic aberration. The total probe profile may thus be calculated as:

$$H_z(\mathbf{r}) = \int \exp\left(-\frac{\Delta E}{2\sigma_E^2}\right) |FT\{P(\mathbf{k}) \exp(i\pi z |\mathbf{k}|^2)\Phi(\mathbf{k}; \Delta E)\}(\mathbf{r})|^2 \, d\Delta E,$$

where $\exp[-\Delta E/(2\sigma_E^2)]$ represents the Gaussian distribution of $\Delta E$, and $\sigma_E$ is the variance of $\Delta E$. The distribution of $\Delta E$ may depend on the exact nature of the charged particle source 201, and the Gaussian distribution used above is only one example of a possible distribution.

If the charged particle source 201 is not exactly an infinitely small point source, the formula for the probe profile $H_z(r)$ may further be modified as follows:

$$H_z(\mathbf{r}) = \left[\int \exp\left(-\frac{\Delta E}{2\sigma_E^2}\right) |FT\{P(\mathbf{k}) \exp(i\pi z |\mathbf{k}|^2)\Phi(\mathbf{k}; \Delta E)\}(\mathbf{r})|^2 \, d\Delta E\right] * \exp\left(-\frac{|\mathbf{r}|^2}{2\sigma_S^2}\right),$$

where * is the convolution operator, $\exp[-|\mathbf{r}|^\wedge 2/(2\sigma_S^2)]$ represents the Gaussian distribution of source intensity and $\sigma_S$ is the variance of the source intensity. The distribution of source intensity depends on the exact nature of the charged particle source 201, and the Gaussian distribution used above is only one example of a possible distribution.

The formula for the probe profile $H_z(r)$ may further be modified to take into account the variation of the stigmator value, for example when the stigmator value is deliberately adjusted so as to adjust the measurement condition. This can be expressed by the additional term $\exp(i2\pi\Delta\zeta_j Z_j(\mathbf{k}))$, where $Z_j(\mathbf{k})$ is the Zernike polynomial that describes the astigmatism induced by the stigmator value and $\Delta\zeta_j$ is the relative change of the corresponding aberration value. For Zernike polynomials, j=5 and j=6 are two types of astigmatism: along the x-y axes or at 45 degrees with respect to the x-y axes.

The method 100 comprises a step 160 of updating the estimated aberration parameter. In an embodiment, the estimated aberration parameter is updated based on the gradient of the error function. The gradient of the error function may provide an indication whether to increase or decrease the estimated aberration parameter so as to decrease the value of the error function. The gradient of the error function may provide an indication as to how much to increase or decrease the estimate aberration parameter. The gradient of the error function may be used to update the estimated aberration parameter such that the value of the error function is decreased compared to the value of the error function based on the previous estimated aberration parameter.

The method 100 comprises iteratively performing the step 130 of evaluating the error function, optionally the step 130' of calculating the gradient of the error function, and the step 160 of updating the estimated aberration parameter. Put another way, the steps 130 and 160, and optionally the step 130', are performed repeatedly. The number of iterations may be predetermined. The method 100 may comprise determining the final aberration parameter as the estimated aberration parameter that provides the smallest value of the error function.

In an embodiment, the method 100 comprises iteratively performing the step 130 of evaluating the error function, optionally the step 130' of calculating the gradient of the error function, and the step 160 of updating the estimated aberration parameter, until the value of the error function is below a threshold, in particular a predetermined threshold. The method 100 may comprise iteratively performing the steps of comparing the value of the error function to the predetermined threshold, updating the estimated aberration parameter when the value of the error function is greater than the predetermined threshold, and evaluating the error function based on the updated estimated aberration parameter.

Additionally, the method 100 may comprise iteratively performing the step 130 of evaluating the error function, the step 130' of calculating the gradient of the error function, and the step 160 of updating the estimated aberration parameter, until also the gradient of the error function is below a second threshold, in particular a second predetermined threshold. The method 100 may comprise iteratively performing the steps of comparing the gradient of the error function to the second predetermined threshold, updating the estimated aberration parameter when the gradient of the error function is greater than the second predetermined threshold, and calculating the gradient of the error function based on the updated estimated aberration parameter.

The estimated aberration parameter is thus updated iteratively until the value of the error function and optionally the gradient of the error function is equal to or below a respective threshold. The method 100 comprises a step 170 of determining the final aberration parameter that provided the value of the error function below the threshold. The final aberration parameter may be set equal to the estimated aberration parameter that provided a value of the error function or the gradient of the error function below the threshold. Evaluating the error function based on the final aberration parameter may thus provide a minimum or substantially minimum value of the error function. The final aberration parameter may thus be a comparably accurate representation of the actual aberrations in the two or more images.

The method 100 may comprise a step 180 of removing or reducing the contribution of the aberrations from at least one image of the sample 208 obtained by the charged particle beam tool 40. The contribution of the aberrations may be removed or reduced based on the final aberration parameter. The at least one image may be at least one image of the two or more images obtained by the charged particle beam tool 40 in step 110. For example, taking into account that $I_z(r) = O(r) * H_z(r; \zeta)$, removing or reducing the contribution of the aberrations from the at least one image $I_z(r)$ may comprise performing deconvolution of the at least one image $I_z(r)$ with the probe profile $H_z(r; \zeta)$ calculated based on the final aberration parameter, thereby extracting the object $O(r)$ from the at least one image $I_z(r)$.

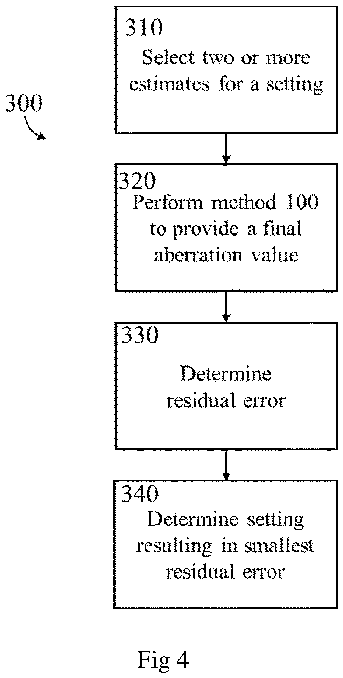

FIG. 4 shows a method 300 of determining a setting, in particular an actual setting, of the charged particle beam tool 40 in accordance with an embodiment of the present invention. The setting of the charged particle beam tool 40 may be the numerical aperture NA of the objective lens 231. Alternatively, the setting of the charged particle beam tool 40 may be the nominal wavelength $\lambda$ of the charged particles used in the charged particle beam tool 40. The nominal wavelength $\lambda$ of the charged particles may be the average of mean wavelength $\lambda$ of the charged particles. The setting of the charged particle beam tool 40 may be any other setting or parameter that has an effect on the probe profile of the primary charged particle beam 202.

In some situations, the setting of the charged particle beam tool 40 may only be known approximately. For example, in some situations, the numerical aperture NA of the objective lens 231 or the wavelength $\lambda$ of the charged particles may be known only approximately. The settings of the charged particle beam tool 40 affect the probe profile of the primary charged particle beam 202. Therefore, any inaccuracies in the setting of the charged particle beam tool 40 may contribute to the error function. Using approximate estimates for the settings of the charged particle beam tool 40 in the method 100 of determining aberrations may have an effect on the value of the error function. In particular, the approximate estimates for the settings will contribute to a residual error of the error function when evaluated based on the final aberration parameter. This residual error may be taken into account to determine the actual setting of the charged particle beam tool 40.

The method 300 may comprise a step 310 of selecting two or more estimates for the setting of the charged particle beam tool 40. The two or more estimates may comprise two or more estimates at regular intervals within an estimated range of the setting. For example, an operator of the charged particle beam tool 40 may know that the numerical aperture NA of the charged particle beam tool 40 is in the range between 0 mrad and 30 mrad, but may not know the exact numerical aperture NA. The two or more estimates may comprise all numerical apertures within the range at 1 mrad intervals.

The method 300 may further comprise a step 320 of performing the method 100 of determining aberrations in images for each of the selected two or more estimates of the setting. Each time the method 100 is performed, the error function may be evaluated based on a different one of the two or more estimates for the setting. For each one of the two or more estimates for the setting, a respective final aberration parameter may be determined.

The method 300 may further comprise a step 330 of determining a residual error for each estimate of the setting. The residual error may be determined by evaluating the error function based on each estimate for the setting and the respective final aberration parameter determined for the respective setting. The residual error will be smaller if the estimate for the setting is relatively accurate (i.e. close to the actual value of the setting), and will be greater if the estimate for the setting is relatively inaccurate (i.e. further away from the actual value of the setting).

The method 300 may further comprise a step 340 of determining, as the setting of the charged particle beam tool 40, the estimate of the setting that results in the smallest residual error. This may be achieved by comparing the residual errors for each respective estimate of the setting and identifying the smallest residual error and associated estimate of the setting. Optionally, determining the setting that results in the smallest residual error may comprise plotting a curve of the determined residual errors, and identifying the setting corresponding to the minimum of the curve. The curve may be fitted to the residual errors that were determined. The curve may be fitted to a polynomial curve, a spline curve, a Gaussian curve, or any other curve. The smallest residual error may be determined from the fitted curve. This may reduce the number of different settings of the charged particle beam tool 40 that need to be considered to arrive at an accurate estimate of the actual setting.

The method 300 may comprise determining the final aberration parameter, i.e. the final aberration parameter that is considered to be closest to the actual aberration parameter, by performing the method 100 using the setting of the charged particle beam tool 40 determined by step 340 of the method 300.

In an embodiment, the charged particle beam tool 40 comprises the illumination system and the detection system. The illumination system is configured to generate a charged particle beam and scan the charged particle beam across the sample 208. The detection system is configured to capture charged particles interacting with the sample, thereby creating an image of the sample. The charged particle tool 40 comprises the controller 50. The controller 50 is configured to perform the method 100 and/or the method 300. The charged particle beam tool 40 may be an electron beam tool.

In an embodiment, there is provided a computer program product. The computer program product comprises instructions which, when the program is executed by a computer, cause the computer to carry out the method 100 and/or the method 300.

In an embodiment, there is provided a computer-readable storage medium. The computer-readable storage medium comprises instructions which, when executed by a computer, cause the computer to carry out the method 100 and/or the method 300.

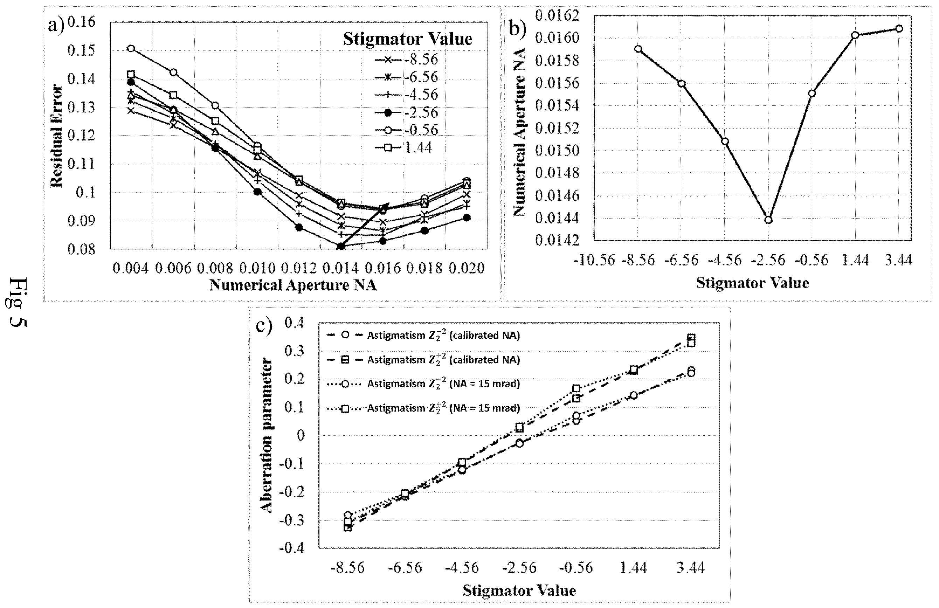

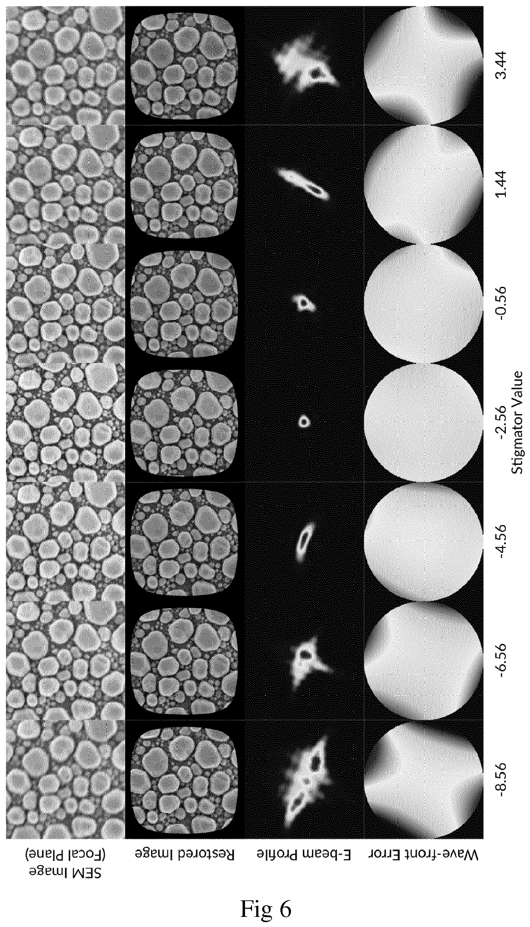

Figures 5 and 6 show experimental results obtained by performing the method 100, thereby determining aberrations in images captured by an SEM, and by performing the method 300, thereby determining the numerical aperture NA of the SEM. The stigmator value (indicative of the astigmatism of the electron beam of the SEM) was deliberately varied, so as to induce different amounts of aberration in the images obtained by the SEM. For each stigmator value, three images were measured: one in the plane of focus and two in defocused planes ($\pm$400 nm). The method 100 was performed initially based on an estimate of the numerical aperture NA of 15 mrad, and a final aberration parameter was determined for each stigmator value. As shown by the dotted curves in the **FIG. 5c,** a linear relation between the determined final aberration parameters and the stigmator values can be observed for NA = 15 mrad.

The method 300 was then performed by selecting estimates for the numerical aperture NA ranging from 4 mrad to 24 mrad in 2 mrad steps, and performing the method 100 based on each of these selected estimates for the numerical aperture NA. The residual error was determined for each combination of stigmator value (i.e. level of aberration) and numerical aperture NA estimate. The results are plotted in **FIG. 5a,** which shows that the residual error depends on the numerical aperture NA estimate for each stigmator value. Furthermore, the minimum residual error is obtained at a different numerical aperture NA estimate for different stigmator values. This is also shown in **FIG.** 5b, in which the numerical aperture NA estimate that was determined to corresponds to the actual numerical aperture NA (i.e. the numerical aperture NA estimate corresponding to the minimum residual error in **FIG. 5a**) is plotted against the stigmator value. As apparent from **FIG. 5b,** the actual numerical aperture NA of the SEM changes as the stigmator value is adjusted. Finally, the dashed lines in **FIG. 5c** show the relation between final aberration parameters and the stigmator values for a calibrated numerical aperture NA, i.e. when using the numerical apertures NA determined by the method 300. As readily apparent, the correlation between the determined final aberration parameters and the stigmator values is improved compared to the situation in which the numerical aperture NA estimate was fixed at 15 mrad.

**FIG. 6** shows the SEM image obtained in the plane of focus of the SEM for different stigmator values, along with images that were restored based on the final aberration parameters determined by method 100 and based on the calibrated numerical aperture NA determined by the method 300 for each stigmator value. **FIG. 6** also shows the calculated probe profile and the wavefront error at each stigmator value.

The embodiments may further be described using the following clauses:

1. A method of determining aberrations in images obtained by a charged particle beam tool, the method comprising the steps of:

a) obtaining two or more images of a sample using the charged particle beam tool, wherein each image is obtained at a known relative difference in a measurement condition of the charged particle beam tool;
b) selecting an estimated aberration parameter for the aberrations of a probe profile representing the charged particle beam used by the charged particle beam tool;
c) evaluating an error function indicative of the difference between the two or more images and two or more estimated images that are a function of the estimated aberration parameter and the known relative difference in the measurement condition;
d) updating the estimated aberration parameter;
e) performing steps c) and d) iteratively; and
f) determining the final aberration parameter as the estimated aberration parameter that provides the smallest value of the error function.

2. The method of clause 1, wherein step e) comprises performing steps c) and d) iteratively until the value of the error function is below a threshold.

3. The method of clause 1 or 2, wherein updating the estimated aberration parameter comprises calculating a gradient of the error function based on the estimated aberration parameter, and updating the estimated aberration parameter based on the gradient of the error function.

4. The method of clause 3, wherein step e) comprises performing steps c) and d) iteratively until the gradient of the error function is below a second threshold.

5. The method of any preceding clause, wherein evaluating the error function comprises:

calculating an estimated probe profile for each image based on the estimated aberration parameter and the known relative difference in the measurement condition,
calculating, for each image of the two or more images, the difference between the image and an estimated image that is estimated based on a respective estimated probe profile, and
summing the calculated differences.

6. The method of any preceding clause, wherein the error function $L(\zeta)$ is

$$L(\boldsymbol{\zeta}) = \sum_z \int \left[ \frac{|\sum_z \hat{I}_z(\boldsymbol{k}) \hat{H}_z(\boldsymbol{k};\boldsymbol{\zeta})^*|^2}{\sum_z |\hat{H}_z(\mathbf{k};\boldsymbol{\zeta})|^2} - \sum_z |\hat{I}_z(\boldsymbol{k})|^2 \right] \mathrm{d}\boldsymbol{k}$$

where each $\hat{I}_z(\boldsymbol{k})$ is a respective image of the two or more images in the plane at distance z with respect to the plane of focus and each $\hat{H}_z(\mathbf{r};\zeta)$ is an estimated probe profile for the respective image, wherein the estimated probe profile is calculated based on the estimated aberration parameter $\zeta$ and the known relative difference in the measurement conditions.

7. The method of clauses 3 and 6, wherein the gradient of the error function is

$$L'(\boldsymbol{\zeta}) = \sum_z \int 2\Re \left\{ \frac{[\sum_z \hat{I}_z(\boldsymbol{k}) \hat{H}_z(\boldsymbol{k};\boldsymbol{\zeta})^*][\sum_z \hat{I}_z(\boldsymbol{k})^* \hat{H}_z{}'(\boldsymbol{k};\boldsymbol{\zeta})]}{\sum_z |\hat{H}_z(\boldsymbol{k};\boldsymbol{\zeta})|^2} \right.$$
$$\left. - \frac{|\sum_z \hat{I}_z(\boldsymbol{k}) \hat{H}_z(\boldsymbol{k};\boldsymbol{\zeta})^*|^2 [\sum_z \hat{H}_z(\boldsymbol{k};\boldsymbol{\zeta})^* \hat{H}_z{}'(\boldsymbol{k};\boldsymbol{\zeta})]}{\left( \sum_z |\hat{H}_z(\boldsymbol{k};\boldsymbol{\zeta})|^2 \right)^2} \right\} \mathrm{d}\boldsymbol{k}$$

where $\Re$ represents the real part of the term in brackets, and $\hat{H}_z{}'(\boldsymbol{k};\zeta)$ represents the gradient of $\hat{H}_z(\boldsymbol{k};\zeta)$ with respect to the aberration parameter $\zeta$.

8. The method of any preceding clause, wherein the measurement condition of the charged particle beam tool is one of:

a position of the sample, along a primary optical axis of the charged particle beam tool, relative to the plane of focus of the charged particle beam tool,

an amount of beam shaping applied to the charged particle beam,

an average landing energy of the charged particles in the charged particle beam, or

any combination thereof.

9. The method of any preceding clause, further comprising removing or reducing the aberrations in at least one image of the sample obtained by the charged particle beam tool based on the final aberration parameter.

10. A method of determining a setting of the charged particle beam tool, the method comprising:

performing the method of any one of the preceding clauses two or more times, each time based on a different estimate for the setting of the charged particle beam tool,

determining a residual error for each estimate of the setting by evaluating the error function based on the final aberration parameter determined for the respective estimate of the setting,

determining as the setting of the charged particle beam tool the estimate of the setting resulting in the smallest residual error.

11. The method of clause 10, wherein the setting of the charged particle beam tool is the numerical aperture of an objective lens of the charged particle beam tool and/or the nominal wavelength of the charged particles used in the charged particle beam tool.

12. The method of clause 10 or 11, comprising determining the final aberration parameter by performing the method of any one of clauses 1 to 8 using the determined setting of the charged particle beam tool.

13. The method of any preceding clause, wherein the charged particle beam tool is an electron beam tool, and wherein the charged particle beam is an electron beam.

14. A charged particle beam tool comprising

an illumination system configured to generate a charged particle beam and to scan the charged particle beam across a sample,

a detection system configured to capture charged particles interacting with the sample, thereby creating an image of the sample, and

a controller configured to perform the method of any preceding clause.

15. The charged particle beam tool of clause 14, wherein the charged particle beam tool is an electron beam tool.

16. A computer program product comprising instructions which, when the program is executed by a computer, cause the computer to carry out the method of any one of clauses 1 to 13.

17. A computer-readable storage medium comprising instructions which, when executed by a computer, cause the computer to carry out the method of any one of clauses 1 to 13.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of determining aberrations in images obtained by a charged particle beam tool, the method comprising the steps of:

a) obtaining two or more images of a sample using the charged particle beam tool, wherein each image is obtained at a known relative difference in a measurement condition of the charged particle beam tool;

b) selecting an estimated aberration parameter for the aberrations of a probe profile representing the charged particle beam used by the charged particle beam tool;

c) evaluating an error function indicative of the difference between the two or more images and two or more estimated images that are a function of the estimated aberration parameter and the known relative difference in the measurement condition;

d) updating the estimated aberration parameter;

e) performing steps c) and d) iteratively; and

f) determining the final aberration parameter as the estimated aberration parameter that provides the smallest value of the error function.

2. The method of claim 1, wherein step e) comprises performing steps c) and d) iteratively until the value of the error function is below a threshold.

3. The method of claim 1, wherein updating the estimated aberration parameter comprises calculating a gradient of the error function based on the estimated aberration parameter, and updating the estimated aberration parameter based on the gradient of the error function.

4. The method of claim 3, wherein step e) comprises performing steps c) and d) iteratively until the gradient of the error function is below a second threshold.

5. The method of claim 1, wherein evaluating the error function comprises:

   calculating an estimated probe profile for each image based on the estimated aberration parameter and the known relative difference in the measurement condition,
   calculating, for each image of the two or more images, the difference between the image and an estimated image that is estimated based on a respective estimated probe profile, and
   summing the calculated differences.

6. The method of claim 1 or 3, wherein the error function $L(\zeta)$ is

$$L(\boldsymbol{\zeta}) = \sum_z \int \left[ \frac{|\sum_z \hat{I}_z(\boldsymbol{k})\hat{H}_z(\boldsymbol{k};\zeta)^*|^2}{\sum_z |\hat{H}_z(\mathbf{k};\zeta)|^2} - \sum_z \left| \hat{I}_z(\boldsymbol{k}) \right|^2 \right] \mathrm{d}\boldsymbol{k}$$

where each $\hat{I}_z(\boldsymbol{k})$ is a respective image of the two or more images in the plane at distance z with respect to the plane of focus and each $\hat{H}_z(\mathbf{r}; \zeta)$ is an estimated probe profile for the respective image, wherein the estimated probe profile is calculated based on the estimated aberration parameter $\zeta$ and the known relative difference in the measurement conditions.

7. The method of claims 3 and 6, wherein the gradient of the error function is

$$L'(\boldsymbol{\zeta}) = \sum_z \int 2\Re \left\{ \frac{\left[\sum_z \hat{I}_z(\boldsymbol{k})\hat{H}_z(\boldsymbol{k};\zeta)^*\right]\left[\sum_z \hat{I}_z(\boldsymbol{k})^*\hat{H}_z'(\boldsymbol{k};\zeta)\right]}{\sum_z \left|\hat{H}_z(\boldsymbol{k};\zeta)\right|^2} \right.$$

$$\left. - \frac{\left|\sum_z \hat{I}_z(\boldsymbol{k})\hat{H}_z(\boldsymbol{k};\zeta)^*\right|^2 \left[\sum_z \hat{H}_z(\boldsymbol{k};\zeta)^*\hat{H}_z'(\boldsymbol{k};\zeta)\right]}{\left(\sum_z \left|\hat{H}_z(\boldsymbol{k};\zeta)\right|^2\right)^2} \right\} \mathrm{d}\boldsymbol{k}$$

where $\Re$ represents the real part of the term in brackets, and $\hat{H}_z'(\boldsymbol{k}; \zeta)$ represents the gradient of $\hat{H}_z(\boldsymbol{k}; \zeta)$ with respect to the aberration parameter $\zeta$.

8. The method of claim 1, wherein the measurement condition of the charged particle beam tool is one of:

   a position of the sample, along a primary optical axis of the charged particle beam tool, relative to the plane of focus of the charged particle beam tool,
   an amount of beam shaping applied to the charged particle beam,
   an average landing energy of the charged particles in the charged particle beam, or
   any combination thereof.

9. The method of claim 1, further comprising removing or reducing the aberrations in at least one image of the sample obtained by the charged particle beam tool based on the final aberration parameter.

10. A method of determining a setting of the charged particle beam tool, the method comprising:

performing the method of claim 1 two or more times, each time based on a different estimate for the setting of the charged particle beam tool,

determining a residual error for each estimate of the setting by evaluating the error function based on the final aberration parameter determined for the respective estimate of the setting,

determining as the setting of the charged particle beam tool the estimate of the setting resulting in the smallest residual error.

11. The method of claim 10, wherein the setting of the charged particle beam tool is the numerical aperture of an objective lens of the charged particle beam tool and/or the nominal wavelength of the charged particles used in the charged particle beam tool.

12. The method of claim 10, comprising determining the final aberration parameter by performing the method of claim 1 using the determined setting of the charged particle beam tool.

13. A charged particle beam tool comprising
an illumination system configured to generate a charged particle beam and to scan the charged particle beam across a sample,
a detection system configured to capture charged particles interacting with the sample, thereby creating an image of the sample, and
a controller configured to perform the method of claim 1.

14. A computer program product comprising instructions which, when the program is executed by a computer, cause the computer to carry out the method of claim 1.

5

Fig 1

Fig 2

110  Obtain two or more images at different known measurement conditions

100

120 Select an estimated aberration value

130' Calculate gradient of error function

130 Evaluate error function

160 Update estimated aberration value

150 Result ≤ threshold

No

Yes

170 Determine final aberration value

180 Remove aberrations from image

Fig 3

300

**310**
Select two or more
estimates for a setting

**320**
Perform method 100
to provide a final
aberration value

**330**
Determine
residual error

**340**
Determine setting
resulting in smallest
residual error

Fig 4

Fig 5

Fig 6

Europäisches
Patentamt

European
Patent Office

Office européen
des brevets

# EUROPEAN SEARCH REPORT

Application Number

EP 19 20 4524

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 328 168 A1 (HITACHI HIGH TECH CORP [JP]) 1 June 2011 (2011-06-01) <br> * abstract * <br> * paragraphs [0013], [0014], [0017] - [0071]; figures 1-3,11-15 * | 1-4,8,9, 13,14 | INV.<br>H01J37/153<br>H01J37/22<br>H01J37/28 |
| A | US 2009/268969 A1 (THUST ANDREAS [DE] ET AL) 29 October 2009 (2009-10-29) <br> * abstract * <br> * paragraphs [0015], [0016], [0041], [0052], [0066], [0098]; claims 1,23,33 * | 3,4 | |
| A | US 2011/272578 A1 (HIROSE KOTOKO [JP] ET AL) 10 November 2011 (2011-11-10) <br> * abstract * <br> * paragraphs [0030], [0056], [0071] - [0096] * | 1,13,14 | |
| A | KENJI NAKAHIRA ET AL: "A New Image Restoration Technique for SEM", PROCEEDINGS OF THE 17TH INTERNATIONAL FEDERATION OF AUTOMATIC CONTROL WORLD CONGRESS, vol. 8189, 11 July 2008 (2008-07-11), page 8185, XP055107895, DOI: 10.3182/20080706-5-KR-1001.01385 <br> * abstract * <br> * figures 1-3 * | 1,13,14 | |

TECHNICAL FIELDS SEARCHED (IPC)

H01J

~~The present search report has been drawn up for all claims~~

| Place of search | Date of completion of the search | Examiner |
|---|---|---|
| Munich | 14 April 2020 | Lang, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 19 20 4524

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-4, 9, 13, 14(completely); 8(partially)

☐ The present supplementary European search report has been drawn up for those parts of the European patent application which relate to the invention first mentioned in the claims (Rule 164 (1) EPC).

24

Europäisches
Patentamt

European
Patent Office

Office européen
des brevets

**LACK OF UNITY OF INVENTION**
**SHEET B**

The Search Division considers that the present European patent application does not comply with the requirements of unity of invention and relates to several inventions or groups of inventions, namely:

1. claims: 1-4, 9, 13, 14(completely); 8(partially)

   A method of determining aberrations in images obtained by a charged particle beam tool, the method comprising the steps of:
   a) obtaining two or more images of a sample using the charged particle beam tool, wherein each image is obtained at a known relative difference in a measurement condition of the charged particle beam tool;
   b) selecting an estimated aberration parameter for the aberrations of a probe profile representing the charged particle beam used by the charged particle beam tool;
   c) evaluating an error function indicative of the difference between the two or more images and two or more estimated images that are a function of the estimated aberration parameter and the known relative difference in the measurement condition;
   d) updating the estimated aberration parameter;
   e) performing steps c) and d) iteratively; and
   f) determining the final aberration parameter as the estimated aberration parameter that provides the smallest value of the error function (claim 1),
   wherein updating the estimated aberration parameter comprises calculating a gradient of the error function based on the estimated aberration parameter, and updating the estimated aberration parameter based on the gradient of the error function (claim 3),
   wherein step e) comprises performing steps c) and d) iteratively until the gradient of the error function is below a second threshold (claim 4).
   ---

2. claims: 5-7

   The method of claim 1, wherein evaluating the error function comprises:
   calculating an estimated probe profile for each image based on the estimated aberration parameter and the known relative difference in the measurement condition,
   calculating, for each image of the two or more images, the difference between the image and an estimated image that is estimated based on a respective estimated probe profile, and summing the calculated differences (claim 5); or
   wherein the error function L (Zeta) is as defined by the formula of claim 6, wherein the estimated probe profile is calculated based on the estimated aberration parameter Zeta and the known relative difference in the measurement conditions (claims 6-7)
   ---

3. claim: 8(partially)

Europäisches
Patentamt

European
Patent Office

Office européen
des brevets

LACK OF UNITY OF INVENTION
SHEET B

The Search Division considers that the present European patent application does not comply with the requirements of unity of invention and relates to several inventions or groups of inventions, namely:

The method of claim 1, wherein the measurement condition of the charged particle beam tool is a position of the sample, along a primary optical axis of the charged particle beam tool, relative to the plane of focus of the charged particle beam tool (claim 8, first alternative).

---

4. claim: 8(partially)

The method of claim 1, wherein the measurement condition of the charged particle beam tool is an average landing energy of the charged particles in the charged particle beam (claim 8, third alternative).

---

5. claims: 10-12

A method of determining a setting of the charged particle beam tool, the method comprising:
performing the method of claim 1 two or more times, each time based on a different estimate for the setting of the charged particle beam tool,
determining a residual error for each estimate of the setting by evaluating the error function based on the final aberration parameter determined for the respective estimate of the setting,
determining as the setting of the charged particle beam tool the estimate of the setting resulting in the smallest residual error.

---

**EP 3 813 091 A1**

## ANNEX TO THE EUROPEAN SEARCH REPORT
## ON EUROPEAN PATENT APPLICATION NO.

EP 19 20 4524

14-04-2020

| Patent document cited in search report | | Publication date | Patent family member(s) | | Publication date |
|---|---|---|---|---|---|
| EP 2328168 | A1 | 01-06-2011 | EP | 2328168 A1 | 01-06-2011 |
| | | | JP | 5277250 B2 | 28-08-2013 |
| | | | JP | WO2010035386 A1 | 16-02-2012 |
| | | | US | 2011139980 A1 | 16-06-2011 |
| | | | WO | 2010035386 A1 | 01-04-2010 |
| US 2009268969 | A1 | 29-10-2009 | AT | 527631 T | 15-10-2011 |
| | | | CN | 101506839 A | 12-08-2009 |
| | | | DE | 102006038211 A1 | 21-02-2008 |
| | | | DK | 2052360 T3 | 05-12-2011 |
| | | | EP | 2052360 A1 | 29-04-2009 |
| | | | JP | 5546244 B2 | 09-07-2014 |
| | | | JP | 2010500726 A | 07-01-2010 |
| | | | US | 2009268969 A1 | 29-10-2009 |
| | | | WO | 2008019644 A1 | 21-02-2008 |
| US 2011272578 | A1 | 10-11-2011 | JP | 5103532 B2 | 19-12-2012 |
| | | | JP | WO2010082489 A1 | 05-07-2012 |
| | | | US | 2011272578 A1 | 10-11-2011 |
| | | | WO | 2010082489 A1 | 22-07-2010 |

EPO FORM P0459